(19) Europäisches Patentamt
European Patent Office
Office européen des brevets

(11) **EP 2 416 176 A1**

(12) **EUROPEAN PATENT APPLICATION**
published in accordance with Art. 153(4) EPC

(43) Date of publication:
08.02.2012 Bulletin 2012/06

(51) Int Cl.:
*G01T 1/18* (2006.01)  *G01T 1/20* (2006.01)
*H01J 31/50* (2006.01)

(21) Application number: 10758456.7

(22) Date of filing: 19.03.2010

(86) International application number:
PCT/JP2010/054836

(87) International publication number:
WO 2010/113682 (07.10.2010 Gazette 2010/40)

(84) Designated Contracting States:
AT BE BG CH CY CZ DE DK EE ES FI FR GB GR HR HU IE IS IT LI LT LU LV MC MK MT NL NO PL PT RO SE SI SK SM TR

(30) Priority: 01.04.2009  JP 2009089351
09.09.2009  JP 2009207779

(71) Applicants:
• Tokuyama Corporation
Shunan-shi, Yamaguchi-ken 745-8648 (JP)
• Tohoku University
Aoba-ku
Sendai-shi
Miyagi 980-8577 (JP)
• Kyoto University
Sakyo-ku
Kyoto-shi
Kyoto 606-8501 (JP)
• The University of Tokyo
Bunkyo-Ku
Tokyo 113-8654 (JP)

(72) Inventors:
• FUKUDA, Kentaro
Shunan-shi
Yamaguchi 745-8648 (JP)
• ISHIZU, Sumito
Shunan-shi
Yamaguchi 745-8648 (JP)

• KAWAGUCHI, Noriaki
Shunan-shi
Yamaguchi 745-8648 (JP)
• SUYAMA, Toshihisa
Shunan-shi
Yamaguchi 745-8648 (JP)
• YOSHIKAWA, Akira
Sendai-shi
Miyagi 980-8577 (JP)
• YANAGIDA, Takayuki
Sendai-shi
Miyagi 980-8577 (JP)
• YOKOTA, Yui
Sendai-shi
Miyagi 980-8577 (JP)
• KUBO, Hidetoshi
Kyoto-shi
Kyoto 606-8502 (JP)
• TANIMORI, Toru
Kyoto-shi
Kyoto 606-8502 (JP)
• SEKIYA, Hiroyuki
Tokyo 113-8654 (JP)

(74) Representative: **Jackson, Martin Peter**
J.A. Kemp & Co.
14 South Square
Gray's Inn
London WC1R 5JJ (GB)

(54) **RADIOGRAPHIC IMAGE DETECTOR**

(57)    [Problems to be Solved] It is an object of the present invention to provide a novel radiographic image detector which can detect radiation, such as hard X-rays or γ-rays, with high sensitivity and which is excellent in position resolution and count rate characteristic.

[Means to Solve the Problems] A radiographic image detector comprises a combination of a scintillator, such as a lanthanum fluoride crystal containing neodymium, for converting incident radiation into ultraviolet rays; and a gas multiplication ultraviolet image detector for converting ultraviolet rays into electrons, amplifying such electrons by use of a gas electron avalanche phenomenon, and detecting the electrons. The radiographic image detector is **characterized in that** the gas multiplication ultraviolet image detector is basically constituted by a photoelectric conversion substance, such as cesium iodide or cesium telluride, for converting ultraviolet rays into electrons; a gas electron multiplier for amplifying electrons by use of the gas electron avalanche phenomenon; and a pixel electrode having an amplification func-

tion and a detection function.

# Fig. 1

**Description**

Technical Field:

This invention relates to a novel radiographic image detector. The radiographic image detector can be used preferably in medical fields such as positron emission tomography and X-ray CT, industrial fields such as various nondestructive tests, and security fields such as radiation monitors and inspection of personal belongings.

Background Art:

Radiation application technologies (i.e.,technologies utilizing radiation) cover a wide range of fields, including medical fields such as positron emission tomography and X-ray CT, industrial fields such as various nondestructive tests, and security fields such as radiation monitors and inspection of personal belongings, and are making marked progress even now.
Radiographic image detectors are constituent technologies occupying an important position in the radiation application technologies. With the progress of the radiation application technologies, the radiographic image detectors are required to achieve higher performance in connection with detection sensitivity, position resolution on the incident position of radiation, or count rate characteristic. As the radiation application technologies find widespread use, cost reduction and an increased sensitive volume are also demanded of the radiographic image detectors.

To fulfill the above demands made on the radiographic image detectors, a particle beam image detector using gas multiplication (maybecalledamplification) byapixelelectrode has been developed (see Patent Document 1). The particle beam image detector allows an incident particle beam to ionize gas molecules, thereby producing electrons, and detects the electrons by the pixel electrode. The particle beam image detector is advantageous in that it is excellent in position resolution and count rate characteristic, can easily increase the sensitive volume, and can be manufactured inexpensively. However, the gas used therein has a low atomic weight, and thus shows low stopping power against photons having high energy, such as hard X-rays and gamma rays. The particle beam image detector, therefore, posed the problem of low detection sensitivity to these photons.

In the light of such problems, the present inventors have already proposed a method comprising converting incident radiation into ultraviolet rays with the use of a scintillator composed of a chemical substance having a large atomic weight, and detecting the ultraviolet rays by a gas multiplication detector having position resolution (see Patent Document 2). An attempt to detect radiation by a similar method has also been made by other people (see Non-Patent Document 1). With these methods, however, the ultraviolet rays produced by the scintillator ionize gas molecules to generate electrons, and the resulting electrons are detected. Thus, the range (i.e., the travel distance before energy loss) of the ultraviolet rays covers an extent corresponding to the thickness of a gas layer. Consequently, such detectors, when used as radiographic image detectors, have posed the problem of declining in position resolution and count rate characteristic. Since chemically unstable gas molecules need to be used, moreover, the problem has occurred that the gas molecules themselves deteriorate, or the gas molecules deposit on the electrode of the detector. These problems have posed difficulty in operating the detectors stably for a long term (see Non-Patent Document 2).

Another attempt has been made at a method for detecting ultraviolet rays produced from radiation by a scintillator, the method comprising converting the ultraviolet rays into electrons with the use of a photoelectric conversion substance, and detecting the electrons by a gas multiplication detector (see Non-Patent Document 3). According to this method, the above-mentioned decreases in position resolution and count rate characteristic and the problem about the stability of operation are considered to be avoidable, but it has been unsuccessful to sufficiently increase a multiplication factor in multiplying or amplifying the electrons by the gas multiplication detector. As a result, very feeble ultraviolet rays generated from the scintillator have not been detectable with satisfactory sensitivity. To date, there have been no attempts to prepare an apparatus which can detect a radiographic image by such a method using a photoelectric conversion substance.

Prior Art Documents:

Patent Documents:

Patent Document 1: Japanese Patent No. 3354551
Patent Document 2: JP-A-2008-202977

Non-Patent Documents:

Non-Patent Document 1: P. Schotanus, et al., "Detection of LaF3:Nd3+ Scintillation Light in a Photosensitive Mutiwire Chamber" Nuclear Instruments and Methods in Physics Research, A272, 913-916 (1988).
Non-Patent Document 2: J. Va'vra, "Wire Aging of Hydrocarbon Gases with TMAE Additions" IEEE Transactions on Nuclear Science, NS-34, 486-490 (1987).
Non-Patent Document 3: J. van der Marel, et al., "A LaF3:Nd (10%) Scintillation Detector with Microgap Gas Chamber Read-out for the Detection of γ-rays" Nuclear Instruments and Methods in Physics Research, A392, 310-314 (1997).

Summary of the Invention:

Problems to be solved by the invention:

It is an object of the present invention to provide a radiographic image detector which can detect radiation, such as hard X-rays or γ-rays, with high sensitivity and which is excellent in position resolution and count rate characteristic, the radiographic image detector being composed of a combination of a scintillator for converting incident radiation into ultraviolet rays, and a novel gas multiplication ultraviolet image detector for converting ultraviolet rays into electrons, amplifying such electrons, and detecting the amplified electrons.

Means for solving the problems:

The present inventors have paid attention to a gas multiplication ultraviolet image detector constituting a radiographic image detector, and conducted extensive studies on a method for detecting very feeble ultraviolet rays, which are produced by a scintillator, with satisfactory sensitivity.
As a result, they have found that using a gas multiplication ultraviolet image detector composed of a photoelectric conversion substance, a gas electron multiplier, and a pixel electrode, ultraviolet rays produced by a scintillator are converted into electrons by the photoelectric conversion substance, and then the electrons are amplified by the gas electron multiplier, and then the amplified electrons are detected with the use of the pixel electrode, whereby radiation can be detected with satisfactory sensitivity. They have also succeeded in obtaining a radiographic image by a radiographic image detector comprising a combination of the scintillator and the gas multiplication ultraviolet image detector. This success has led them to accomplish the present invention.
That is, according to the present invention, there is provided a radiographic image detector including a scintillator for converting incident radiation into ultraviolet rays, and a gas multiplication ultraviolet image detector, wherein the gas multiplication ultraviolet image detector is composed of a photoelectric conversion substance, a gas electron multiplier, and a pixel electrode.
In the above invention of the radiographic image detector, it is preferred that

(1) the scintillator be a metal fluoride crystal containing neodymium, praseodymium, thulium or erbium;
(2) the photoelectric conversion substance be cesium iodide or cesium telluride; and
(3) two or three of the gas electron multipliers be present.

Effects of the invention:

According to the present invention, extremely feeble ultraviolet rays produced upon conversion from radiation by the scintillator can be detected with high sensitivity. Thus, a radiographic image detector excellent in position resolution and count rate characteristic can be provided. Moreover, the radiographic image detector of the present invention can easily upsize the sensitive volume, and can be manufactured at a low cost. Hence, the radiographic image detector of the present invention is of immense value in the fields of medicine, industry, security, etc.

Brief Description of the Drawings:

[Fig. 1] is a schematic view of a radiographic image detector according to the present invention.
[Fig. 2] is a schematic view of a radiographic image detector according to the present invention.
[Fig. 3] is a schematic view of a radiographic image detector according to the present invention.

[Fig. 4] is a schematic view of a radiographic image detector according to the present invention.
[Fig. 5] shows schematic views of a gas electron multiplier used in the present invention.
[Fig. 6] is a radiographic image obtained in Example 1.
[Fig. 7] is a radiographic image obtained in Example 2.
[Fig. 8] is a radiographic image obtained in Example 3.
[Fig. 9] is a radiographic image obtained in Example 3.
[Fig. 10] is a radiographic image obtained in Example 3.
[Fig. 11] shows the profiles of radiation detection frequencies in the radiographic images obtained in Example 3.

Mode for Carrying Out the Invention:

[Operating principle]

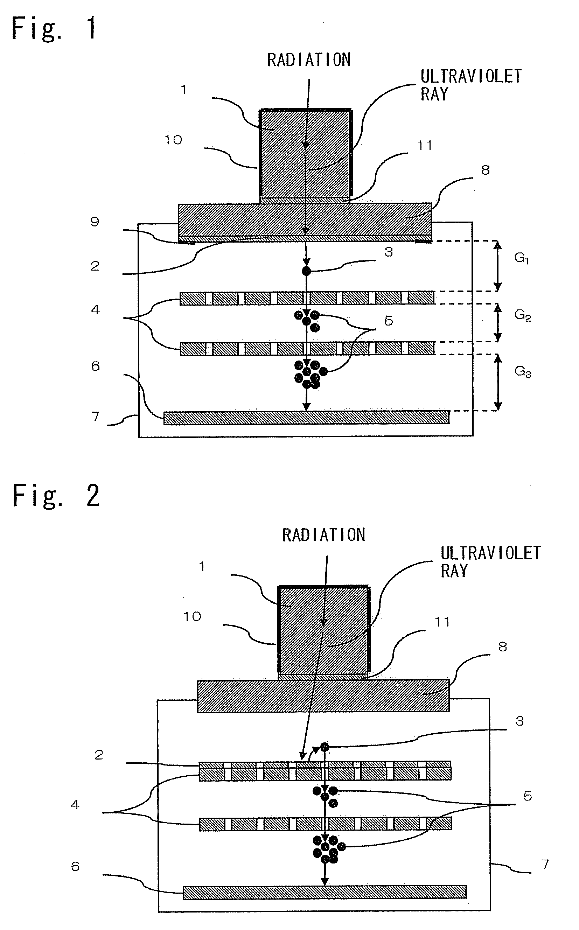

The operating principle of the radiographic image detector according to the present invention will be described using Fig. 1. First, incident radiation is converted into ultraviolet rays by a scintillator 1. Then, the resulting ultraviolet rays are converted into primary electrons 3 by a photoelectric conversion substance 2. The primary electrons 3 are amplified by gas electron multipliers 4, which utilize a multiplication effect due to a gas electron avalanche phenomenon in a high electric field, to obtain secondary electrons 5. Then, the secondary electrons 5 are further amplified and detected by a pixel electrode 6. Signals based on the electrons detected by the pixel electrode are processed by an external circuit, whereby the position of incidence of the radiation can be identified to obtain a radiographic image. The radiographic image detector of the present invention will be described in more detail below.

[Scintillator]

As the scintillator which is a constituent element of the radiographic image detector of the present invention, any scintillator producing ultraviolet rays upon entry of radiation can be used without limitation. In the light of the efficiency of photoelectric conversionfrom ultravioletraysinto electrons in the photoelectric conversion substance, however, it is particularly preferred to use a scintillator which produces vacuum ultraviolet rays with a wavelength of 200 nm or less among ultraviolet rays.
By selecting the scintillator used, in accordance with the type of radiation to be detected, any radiation such as X-rays, $\alpha$-rays, $\beta$-rays, $\gamma$-rays or neutron beam becomes detectable. In particular, the scintillator comprising a chemical substance having a high atomic weight is preferred, because it can efficiently detect photons of high energy, such as hard X-rays or $\gamma$-rays, among radiations.
In order to allow the ultraviolet rays, produced by the entry of radiation, to exit without being absorbed by the scintillator itself, it is preferred to use a scintillator which minimally absorbs ultraviolet rays. Examples of such a scintillator minimally absorbing ultraviolet rays include scintillators composed of metal fluorides to be described later; metal oxides such as alumina ($Al_2O_3$), yttrium aluminate ($YAlO_3$) and lutetium aluminate ($Lu_3Al_5O_{12}$); metal phosphates such as lutetium phosphate ($LuPO_4$) and yttrium phosphate ($YPO_4$); or some metal borates.
The forms of these scintillators are not limited, and any forms such as crystal, glass and ceramic can be used as appropriate. From the viewpoint of the efficiency of conversion from radiation into ultraviolet rays, the use of a crystal is preferred.
As the scintillator which produces the vacuum ultraviolet rays, the metal fluoride can be used preferably. Since vacuum ultraviolet rays have the property of being absorbed by many materials, the problem occurs that vacuum ultraviolet rays generated by the entry of radiation are absorbed by the scintillator itself. However, the metal fluoride, as an exception, has the property of minimally absorbing vacuum ultraviolet rays, and thus can be used preferably in the present invention. The type of the metal fluoride is not limited, and any publicly known metal fluorides can be used as the scintillator producing vacuum ultraviolet rays. Concretely, the following metal fluorides are named as examples: lithium fluoride, magnesium fluoride, calcium fluoride, scandium fluoride, titanium fluoride, chromium fluoride, manganese fluoride, iron fluoride, cobalt fluoride, nickel fluoride, copper fluoride, zinc fluoride, gallium fluoride, germanium fluoride, aluminum fluoride, strontium fluoride, yttrium fluoride, zirconium fluoride, barium fluoride, lanthanum fluoride, cerium fluoride, praseodymium fluoride, neodymium fluoride, europium fluoride, gadolinium fluoride, terbium fluoride, erbium fluoride, thulium fluoride, ytterbium fluoride, lutetium fluoride, hafnium fluoride, tantalum fluoride, and lead fluoride.
In the present invention, it is preferred that compounds containing luminescence center elements, which generate radiative transition in the ultraviolet region, be used as the scintillator. Any luminescence center elements may be used without limitation, as long as they show emission of ultraviolet rays by radiative transition. The luminescence center elements, which exhibit 5d-4f transition light emission due to electron transition from 5d level to 4 f level, are particularly preferred, because they have a short light emission lifetime and a fast response. As such luminescence center elements exhibiting 5d-4f transition light emission, praseodymium (Pr), neodymium (Nd), erbium (Er) and thulium (Tm) can be used preferably.

In the scintillator containing the luminescence center element, the content of the luminescence center element varies according to the type of the scintillator or the type of the luminescence center element, but usually, a content in the range of 0.005 to 20 wt.% is preferred. By setting the amount of the luminescence center element added at 0.005 wt.% or more, the intensity of light emission of the scintillator can be enhanced. By setting this amount at 20 wt.% or less, on the other hand, attenuation of light emission by the scintillator ascribed to concentration quenching can be suppressed.

The preferred scintillator containing the luminescence center element is exemplified by crystals comprising the aforementioned metal fluorides, metal oxides, or metal phosphates, the crystals containing the luminescence center element exhibiting the aforesaid 5d-4f transition light emission.

In the present invention, it is preferred to use the scintillator comprising a chemical substance having a high density and a high effective atomic number, in order to enhance the detection sensitivity to photons of high energy, such as hard X-rays or γ-rays. The effective atomic number is an indicator defined by the equation [1] shown below, and affects the stopping power against hard X-rays or γ-rays. The higher the effective atomic number is, the greater the stopping power against hard X-rays or γ-rays becomes. As a result, the sensitivity of the scintillator to hard X-rays or γ-rays increases.

$$\texttt{Effective atomic number} = (\textstyle\sum \texttt{WiZi}^4)^{1/4} \qquad [1]$$

where Wi and Zi denote, respectively, the mass fraction and atomic number of the i-th element of the elements constituting the scintillator.

The shape of the scintillator is not limited. Preferably, however, the scintillator has an ultraviolet emergence surface opposing a gas multiplication ultraviolet image detector to be described later (may hereinafter be referred to simply as an ultraviolet emergence surface), and the ultraviolet emergence surface has been optically polished. By providing such an ultraviolet emergence surface, ultraviolet rays produced by the scintillator can be efficiently entered into the gas multiplication ultraviolet image detector.

The shape of the ultraviolet emergence surface is not limited, and shapes conformed to uses can be suitably selected, such as a square shape several millimeters to several hundred millimeters square, and a circular shape of several millimeters to several hundred millimeters in diameter. The thickness, in the direction of incidence of radiation, of the scintillator varies with the type and energy of the radiation to be detected, but generally, is several hundred micrometers to several hundred millimeters.

Application of an ultraviolet reflective coating or film, which comprises aluminum or Teflon, to a surface not opposing the gas multiplication ultraviolet image detector is preferred, because dissipation of ultraviolet rays produced by the scintillator can be prevented. By using an array of many of the scintillators coated with the ultraviolet reflective film, moreover, the position resolution of the radiographic image detector can be enhanced remarkably.

The method for manufacturing the scintillator is not limited, and the scintillator can be manufactured by a publicly known manufacturing method. In manufacturing a metal fluoride crystal which is the preferred scintillator in the present invention, it is preferred to manufacture it by the melt growth method such as Czochralski method or Bridgman method. Manufacture by the melt growth method enables a metal fluoride crystal excellent in quality, such as transparency, to be produced. Moreover, a large crystal having a diameter of several inches can be produced at a low cost.

In order to eliminate a crystal defect due to thermal strain or the like in the manufacture of the metal fluoride crystal, annealing may be performed after the manufacture of the crystal. The resulting metal fluoride crystal has satisfactory processability and, after being processed into a desired shape, is used as a scintillator. For its processing, a cutter such as a blade saw or a wire saw, a grinder or an abrasive wheel, which is publicly known, can be used without limitation.

The gas multiplication ultraviolet image detector included in the radiographic image detector of the present invention is basically constituted by a photoelectric conversion substance, a gas electron multiplier, and a pixel electrode. The gas multiplication ultraviolet image detector will be described concretely below.

[Photoelectric conversion substance]

The photoelectric conversion substance functions to convert ultraviolet rays, which have been produced by the scintillator, into primary electrons. The photoelectric conversion substance is not limited in type, if it has the above function. Concretely, cesium iodide (CsI) and cesium telluride (CsTe) can be named as examples. Of them, cesium iodide is preferred from the viewpoint of the efficiency of photoelectric conversion in converting ultraviolet rays into electrons, and the viewpoint of chemical stability.

The photoelectric conversion substance is preferably in the form of a thin film for the purpose of efficient withdrawal of primary electrons converted from ultraviolet rays. As will be described later, moreover, it is preferred that the photoelectric conversion substance thin film be formed on the inner surface of an ultraviolet entrance window, or be formed on a surface of the gas electron multiplier opposing the ultraviolet entrance window.

[Gas electron multiplier]

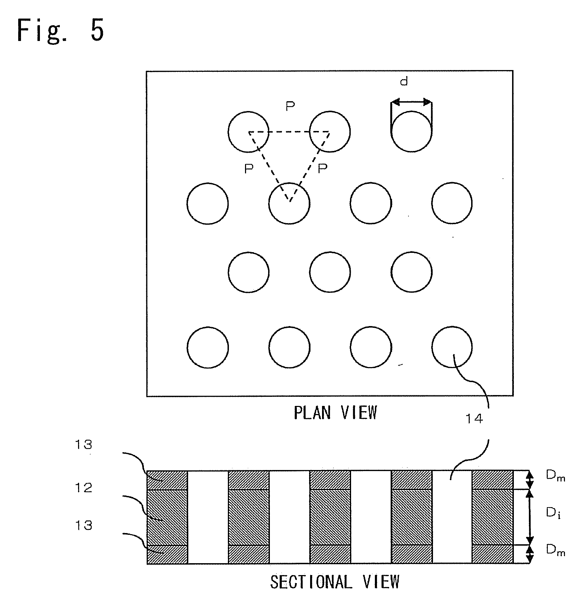

Then, the primary electrons produced by the photoelectric conversion substance are amplified by a gas electron multiplier. The gas electron multiplier was developed by Sauli in 1997, and is known as GEM. In the present invention, the technology described, for example, in JP-A-2006-302844 or JP-A-2007-234485 can be used preferably as the gas electron multiplier. Hereinbelow, the gas electron multiplier used in the present invention will be described in detail with the use of Fig. 5.

The gas electron multiplier is composed of a plate-shaped multilayer body constituted by a plate-shaped insulating layer 12 formed from resin, and planar metal layers 13 coated on both surfaces of the plate-shaped insulating layer; and through-holes 14 provided in the plate-shaped multilayer body and each having an inner wall perpendicular to the flat surfaces of the metal layers. In the gas electron multiplier, a predetermined applied voltage is applied to the metal layers to generate an electric field inside the through-holes. By so doing, the primary electrons entering the interior of the through-hole structure are accelerated to cause an electron avalanche phenomenon, and they are amplified to become many secondary electrons while retaining position information. The material for the plate-shaped insulating layer is preferably a polyimide, a liquid crystal polymer or the like in view of the processability and mechanical strength.

The larger the thickness ($D_i$ in Fig. 5) of the plate-shaped insulating layer, the more effectively discharge between the metal layers on the face and back of the gas electron multiplier can be suppressed. Thus, a higher applied voltage is applied, whereby an increased multiplication factor can be obtained. If the thickness is excessively large, however, processing for providing the through-holes is difficult. Thus, the thickness of the plate-shaped insulating layer is preferably set at 50 $\mu$m to 300 $\mu$m. The material for and thickness ($D_m$ in Fig. 5) of the metal layer are not limited. For example, however, the preferred metal layer is one whose material is copper, aluminum or gold, and whose thickness is of the order of 5 $\mu$m.

The diameter (d in Fig, 5) of the through-hole is not limited, and selected, as appropriate, in consideration of the strength of an electric field generated within the through-hole, the ease of processing, etc. A concrete example of such a diameter is generally 50 to 100 $\mu$m. The through-holes are preferably provided at a predetermined pitch (P in Fig. 5) in the entire plate-shaped multilayer body in order to enhance the uniformity of the electric field generated. This pitch depends on the material for and thickness of the plate-shaped insulating layer and the diameter of the through-hole, but is generally about twice the diameter of the through-hole. In providing the through-holes, they are preferably disposed in an arrangement of regular triangles, as shown in Fig. 5. By adopting such an arrangement, the open area ratio of the through-holes to the area of the plate-shaped multilayer body can be increased. Thus, a high multiplication factor can be obtained, and an ion feedback to be described later can be suppressed.

In the operation of the gas electron multiplier, the higher the applied voltage is, the higher multiplication factor is obtained. If the applied voltage is extremely high, however, discharge occurs between the metal layers on the face and back of the gas electron multiplier, making a stable operation difficult. The preferred range of the applied voltage varies with the thickness of the plate-shaped insulating layer, but is generally 200V to 1,000V. The multiplication factor obtained at such an applied voltage is generally several tens to several thousands.

[Pixel electrode]

Secondary electrons amplified by the gas electron multiplier are further amplified and detected using a pixel electrode. The pixel electrode is disclosed in detail in the aforementioned Patent Document 1, and thus may be prepared in accordance with the technology disclosed therein.

Concretely, the pixel electrode includes anode strips formed on the back of a double-sided substrate, cylindrical anode electrodes planted in the anode strips and each having an upper end surface exposed at the face of the double-sided substrate, and strip-shaped cathode electrodes each having holes formed around the upper end surfaces of the cylindrical anode electrodes. The anode strips each preferably have a width of 200 $\mu$m to 400 $\mu$m. Particularly preferably, the anode strips are arranged at intervals of 400 $\mu$m, the strip-shaped cathode electrodes each have the holes with a diameter of 200 to 300 $\mu$m formed at constant intervals, and the cylindrical anode electrodes each have a diameter of 40 to 60 $\mu$m and a height of 50 to 150 $\mu$m.

By applying a predetermined applied voltage between the cylindrical anode electrode and the strip-shaped cathode electrode of the pixel electrode, a strong electric field occurs in the vicinity of the cylindrical anode electrode. Secondary electrons accelerated by this electric field undergo an electron avalanche and, after being amplified, they are detected by the cylindrical anode electrode. Gas molecules cationized during this process rapidly drift to the surrounding strip-shaped cathode electrode. Thus, electric charges observable on the electric circuit are produced in both of the cylindrical anode electrode and the strip-shaped cathode electrode. Observation of which strip of the anodes and the cathodes the multiplication phenomenon has occurred in, therefore, tells the position of the incident particle beam. As a signal processing circuit for reading out signals and obtaining a two-dimensional image, a publicly known one can be used without limitation.

The preferred range of the applied voltage of the pixel electrode varies according to the type of the gas used, but is generally 400V to 800V. The pixel electrode uses pixels as the anodes, and thus easily creates a high electric field, resulting in a high multiplication factor. Hence, the multiplication factor obtained at the above applied voltage reaches a value as great as several thousands to several tens of thousands. With the pixel electrode, moreover, the distance over which the cationized gas molecules drift is extremely short. Compared with other gas multiplication detectors, therefore, the pixel electrode has a short dead time, and has a high count rate characteristic exceeding about $5 \times 10^6$ counts/(sec•mm$^2$). Furthermore, the pixel electrode can be produced using a technology for preparing a printed circuit board, so that the pixel electrode having a large area can be provided at a low cost.

[Gas multiplication ultraviolet image detector]

A preferred mode for constituting a gas multiplication ultraviolet image detector using the photoelectric conversion substance, gas electron multiplier, and pixel electrode described above will be described in detail with the use of Fig. 1.

Within a chamber 7 having an opening for admitting ultraviolet rays produced by the scintillator 1, the photoelectric conversion substance 2, the gas electron multiplier 4, and the pixel electrode 6 are installed in this sequence, starting on the side nearer the opening, and the opening is sealed with an ultraviolet entrance window 8. As a material for the ultraviolet entrance window, it is preferred to use lithium fluoride (LiF), magnesium fluoride (MgF$_2$) or calcium fluoride (CaF$_2$) which is highly pervious to ultraviolet rays.

The interior of the chamber is filled with a predetermined gas. A combination of a rare gas and a quencher gas is generally used as this gas for electron multiplication. Examples of the rare gas are helium (He), neon (Ne), argon (Ar) and xenon (Xe). Examples of the quencher gas are carbon dioxide (CO$_2$), methane (CH$_4$), ethane (C$_2$H$_6$), and tetrafluoromethane (CF$_4$). The amount of the quencher gas mixed into the rare gas is preferably 5 to 30%.

The photoelectric conversion substance preferably assumes the form of a thin film in order to efficiently withdraw primary electrons converted from ultraviolet rays. This thin film is preferably formed on the inner surface of the ultraviolet entrance window as shown in Fig. 1, or formed on a surface of the gas electron multiplier opposing the ultraviolet entrance window as shown in Fig. 2.

In forming the thin film of the photoelectric conversion substance on the inner surface of the ultraviolet entrance window, it is preferred to provide an electrode 9, which comprises a metal layer, in an outer peripheral portion on the thin film, in order to supply electrons efficiently to the thin film, and in order to provide a uniform electric field between the thin film and the gas electron multiplier. In forming the thin film of the photoelectric conversion substance on the surface of the gas electron multiplier opposing the ultraviolet entrance window, it is preferred to use gold as the material for the metal layer of the gas electron multiplier, in order to avoid a reaction between the metal layer of the gas electron multiplier and the photoelectric conversion substance. Furthermore, in light of the ease of lamination on the plate-shaped insulating layer as well as the manufacturing cost, it is most preferred that the metal layer be rendered a multilayered metal layer composed of layers of copper, nickel and gold laminated in this order, starting on the side closer to the plate-shaped insulating layer.

The gas electron multiplier and the pixel electrode are installed parallel to the ultraviolet entrance window. It is preferred, from the viewpoints of the multiplication factor and the stability of operation, that a plurality of the gas electron multipliers be used, and similarly installed in parallel with the ultraviolet entrance window. Particularly preferably, two or three or so of the gas electron multipliers are installed. By amplifying the electrons by each of the plurality of gas electron multipliers and the pixel electrode, the electrons are amplified stepwise, with the result that the overall multiplication factor obtained can be markedly increased. By using the plurality of gas electron multipliers, moreover, ion feedback can be effectively suppressed, and the stability of operation can be enhanced. The ion feedback refers to a phenomenon in which cationic gas molecules secondarily generated by the electron avalanche phenomenon are accumulated to distort the electric field. Once such an ion feedback occurs, the multiplication factor and the count rate characteristic become unstable, hindering the stability of operation.

The shorter the length of the gap ($G_1$ in Fig. 1) between the ultraviolet entrance window and the gas electron multiplier at the first stage, the shorter the length of the gap ($G_2$ in Fig. 1) between the respective gas electron multipliers, and the shorter the gap ($G_3$ in Fig. 1) between the gas electron multiplier at the last stage and the pixel electrode are, the higher the count rate characteristic and the position resolution become. If any of these lengths is too short, however, it will be difficult to install the adjacent members such that they are out of contact. Thus, the preferred lengths of $G_1$, $G_2$ and $G_3$ are each about 1 mm to 5 mm.

The magnitudes of the electric fields produced in $G_1$, $G_2$ and $G_3$ are not limited, but can be selected, as appropriate, in light of the desired multiplication factor, the effect of suppressing the ion feedback, and the efficiency of charge collection. A concrete example of the preferred range of the electric field is generally 0.3 to 10 kV/cm. By setting the electric field at such a magnitude, a high multiplication factor and the suppression of the ion feedback can be achieved at the same time.

According to investigations by the present inventors, two of the gas electron multipliers and the pixel electrode are combined, and the applied voltages applied to the gas electron multipliers and the pixel electrode are optimized, whereby a multiplication factor exceeding $1 \times 10^5$ can be obtained stably as an overall multiplication factor by the gas electron multipliers and the pixel electrode, so that it has become possible to form an image by feeble ultraviolet rays resulting from the scintillator.

[Radiographic image detector]

In the radiographic image detector of the present invention, high voltage power supplies for applying voltages are connected to the photoelectric conversion substance, the gas electron multipliers, and the pixel electrode. To the pixel electrode, a signal processing circuit for signal readout and for obtaining a two-dimensional image is connected. In performing readout of signals and obtaining a two-dimensional image from the pixel electrode, the use of an Anger signal processing circuit based on the Anger logic can result in a particularly increased position resolution. The Anger logic is a method which, when scintillation light produced by the incidence of radiation is detected with a spatial expanse, determines the position of the center of gravity of the scintillation light, thereby identifying the position of incidence of the radiation.

The Anger signal processing circuit is composed of a readout circuit for reading out the strengths of signals at the respective pixels of the pixel electrode, a coincidence circuit for discriminating scintillation light produced by the incidence of individual radiations, and a center-of-gravity arithmetic circuit for finding the position of the center of gravity of the scintillation light from the strengths of the signals read out of the respective pixels. In the Anger signal processing circuit, of the signals obtained by the readout circuit, only the signal produced by the incidence of single radiation is discriminated by the coincidence circuit. Then, with such a discriminated signal as a target, the weighted average of the strength of the signal is obtained by the center-of-gravity arithmetic circuit, whereby the position of incidence of radiation is pinpointed. According to such an Anger signal processing circuit, the position resolution can be increased to about 100 μm.

A preferred mode for constituting the radiographic image detector of the present invention with the use of the scintillator and the gas multiplication ultraviolet image detector mentioned above will be described in detail using Fig. 1. As shown in Fig. 1, the surfaces of the scintillator other than its ultraviolet emergence surface are provided with an ultraviolet reflective film 10. The scintillator and the gas multiplication ultraviolet image detector are installed, with the ultraviolet emergence surface of the scintillator and the ultraviolet entrance window of the gas multiplication ultraviolet image detector being in intimate contact, and preferably, the clearance between the ultraviolet emergence surface and the ultraviolet entrance window is filled with optical grease 11. By filling the optical grease, ultraviolet rays arriving at the ultraviolet emergence surface from inside the scintillator can be led to the outside without their reflection by the ultraviolet emergence surface, so that the effect of their entry into the gas multiplication ultraviolet image detector can be enhanced. As the optical grease, it is preferred to use fluorine-based optical grease having a high refractive index and high transparency to ultraviolet rays. For example, "Krytox" produced by DuPont can used preferably.

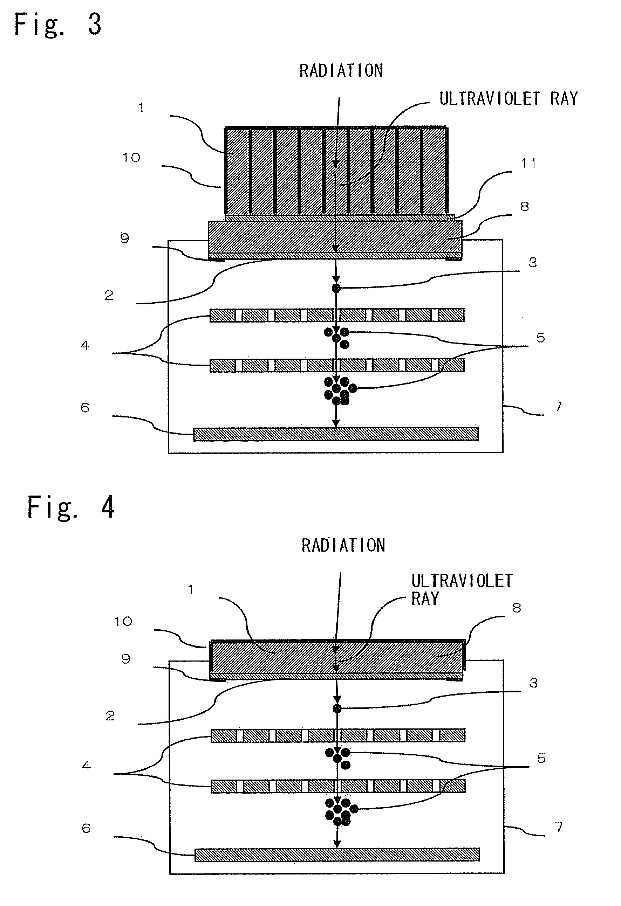

If the thickness of the scintillator in the direction of incidence of radiation is so large that the position resolution declines owing to the spread of ultraviolet rays within the scintillator, many of the scintillators each having a small ultraviolet emergence surface and having the ultraviolet reflective film applied to the surfaces other than the ultraviolet emergence surface are arranged, as shown in Fig. 3. By so doing, spread of the ultraviolet rays can be curtailed.

As another mode of the radiographic image detector according to the present invention, it is permissible to seal the opening of the chamber with the scintillator, instead of the ultraviolet entrance window, as shown in Fig. 4. Such a mode is preferred, because it can avoid a decline in the position resolution, which is ascribed to the spread of ultraviolet rays in the ultraviolet entrance window, and can also simplify the structure.

Examples:

Hereinbelow, the present invention will be described concretely by reference to its Examples, but the present invention is in no way limited by these Examples. Moreover, not all of combinations of the features described in the Examples are essential to the means for solution that the present invention adopts.

Example 1

<Preparation of scintillator>

In the present Example, a lanthanum fluoride crystal containing neodymium as a luminescence center element was used as a scintillator. The lanthanum fluoride crystal containing neodymium was produced using a crystal production apparatus by the Czochralski method. Lanthanum fluoride and neodymium fluoride, each having purity of 99.99% or more, were used as raw materials. First, 2,700 g of lanthanum fluoride and 300 g of neodymium fluoride were weighed, mixed together thoroughly, and charged into a crucible.

Then, the crucible charged with the above materials was installed within a chamber of the crystal production apparatus. After the interior of the chamber was evacuated under vacuum to $1.0 \times 10^{-3}$ Pa or less by use of a vacuum evacuation device, a mixed gas consisting of tetrafluoromethane and argon with high purity was introduced into the chamber to replace the atmosphere inside with the gas. The pressure inside the chamber after gas replacement was set at atmospheric pressure. After the gas replacement operation was performed, the materials were heated with a heater until melting, and a seed crystal was brought into contact with a melt of the molten materials. Then, the seed crystal was pulled up, while being rotated, to initiate the growth of the crystal.

With the crystal being pulled up, the crystal diameter was increased at a constant rate to adjust the crystal diameter to 55 mm. After the crystal diameter was increased to 55 mm, the pull-up rate was maintained at 3 mm/hr, and pulling-up was continued uninterruptedly until the length of the crystal reached about 100 mm. Then, the output of the heater was raised to cut the crystal off the material melt. Then, the crystal was cooled slowly to obtain a lanthanum fluoride crystal containing neodymium. This crystal was 55 mm in diameter and about 100 mm in length, and was a high quality crystal free from cloudiness or cracking. The content of neodymium was 5.9 wt. % when measured using an energy dispersive X-ray spectroscope.

The resulting crystal was processed into a cubic shape 20 mm square by a wire saw with a diamond wire, and was then subjected to optical polishing on all surfaces to prepare a scintillator. One of the optically polished surfaces was used as an ultraviolet emergence surface, while the other surfaces were coated with an ultraviolet reflective filmcomprisingTeflon (a registered trademark). An opening measuring 5 mm X 5 mm was provided at the center of the ultraviolet reflective film applied to the surface opposed to the ultraviolet emergence surface so as to be used as a radiation entrance port. For this scintillator, the wavelength of ultraviolet rays emerging upon conversion of incident radiation was measured by the following method:

The scintillator was irradiated with X-rays with the use of a sealed-off X-ray tube with tungsten as a target. A tube voltage and a tube current for generating X-rays from the sealed-off X-ray tube were set at 60 kV and 40 mA, respectively. Ultraviolet rays appearing from the ultraviolet emergence surface of the scintillator were focused by a focusing mirror, and monochromatized by a spectroscope. The intensity of each wavelength was recorded to obtain a spectrum of the ultraviolet rays produced by the scintillator. The measurements confirmed that the scintillator converted the incident radiation into vacuum ultraviolet rays with a wavelength of 173 nm.

<Preparation of gas multiplication ultraviolet image detector>

A gas multiplication ultraviolet image detector, a constituent of the radiographic image detector of the present invention, was prepared in the following manner:

As shown in Fig. 1, two gas electron multipliers and a pixel electrode were installed parallel in this sequence within a chamber having an opening, starting on the side nearer the opening, and the opening was sealed with an ultraviolet entrance window. The distance between the ultraviolet entrance window and the gas electron multiplier at the first stage was 2.5 mm, the distance between the gas electron multiplier at the first stage and the gas electron multiplier at the subsequent stage was 2 mm, and the distance between the gas electron multiplier at the subsequent stage and the pixel electrode was 2 mm.

The gas electron multipliers used were each prepared by vapor-depositing copper, as a 5 $\mu$m thick metal layer, on both sides of a 50 $\mu$m thick plate-shaped insulating layer of polyimide to form a plate-shaped multilayer body, and providing cylindrical through-holes of 70 $\mu$m in diameter at a pitch of 140 $\mu$m in an arrangement of regular triangles throughout the plate-shaped multilayer body.

The pixel electrode used was composed of a 100 $\mu$m thick polyimide substrate, 300 $\mu$m wide anode strips provided on the back of the substrate, cylindrical anode electrodes arranged at intervals of 400 $\mu$m in such a manner as to be planted in the anode strips and exposed at the face of the substrate, and strip-shaped cathode electrodes provided to have holes of 260 $\mu$m in diameter formed around the upper end surfaces of the cylindrical anode electrodes. The diameter of the cylindrical anode electrode was 50 $\mu$m at its portion embedded in the substrate, and 70 $\mu$m at its portion exposed at the face of the substrate. The height of the cylindrical anode electrode was 110 $\mu$m, and an upper end portion thereof measuring 10 $\mu$m was exposed at the face of the substrate.

For the ultraviolet entrance window, $MgF_2$ having a diameter of 70 mm and a thickness of 5 mm was used. A thin film of cesium iodide was provided, as a photoelectric conversion substance, on the inner surface of the ultraviolet entrance window, and an electrode comprising an aluminum layer was provided in an outer peripheral portion on the cesium iodide thin film. High voltage power supplies for applying applied voltages were connected to the electrode comprising the aluminum layer, which was provided in the outer peripheral portion on the cesium iodide thin film; to both surfaces of the gas electron multiplier at the first stage; to both surfaces of the gas electron multiplier at the subsequent stage; and to the anode electrodes and cathode electrodes of the pixel electrode. A signal processing circuit for reading out signals and obtaining a two-dimensional image was connected to the anode electrodes and cathode electrodes of the pixel electrode.

An Ar gas incorporating 10% of $C_2H_6$ was charged into the chamber to obtain a gas multiplication ultraviolet image detector, a constituent of the present invention.

In the gas multiplication ultraviolet image detector, -1035 V was applied to the electrode comprising the aluminum layer that was provided in the outer peripheral portion on the cesium iodide thin film, 280 V was applied between the metal layers on the opposite surfaces in each of the two gas electron multipliers, and 490 V was applied between the anode electrodes and cathode electrodes of the pixel electrode. The applied voltages were adjusted such that the electric field between the ultraviolet entrance window and the gas electron multiplier at the first stage was 0.5 kV/cm, the electric field between the gas electron multiplier at the first stage and the gas electron multiplier at the subsequent stage was 1.25 kV/cm, and the electric field between the gas electron multiplier at the subsequent stage and the pixel electrode was 2.95 kV/cm.

Under the above applied voltages, the overall multiplication factor obtained by the two gas electron multipliers and the pixel electrode reached $6.7 \times 10^5$. Even at such a high multiplication factor, electric discharge at the face or back of the gas electron multiplier, or electric discharge in the pixel electrode did not occur, and the gas multiplication ultraviolet image detector was confirmed to operate stably for a long period of time.

<Preparation and evaluation of radiographic image detector>

The scintillator and the gas multiplication ultraviolet image detector prepared by the above-described methods were installed, with the ultraviolet emergence surface of the scintillator and the ultraviolet entrance window of the gas multiplication ultraviolet image detector being in intimate contact as shown in Fig. 1, to obtain the radiographic image detector of the present invention. The clearance between the ultraviolet emergence surface and the ultraviolet entrance window was filled with "Krytox" of DuPont as fluorine-based optical grease.

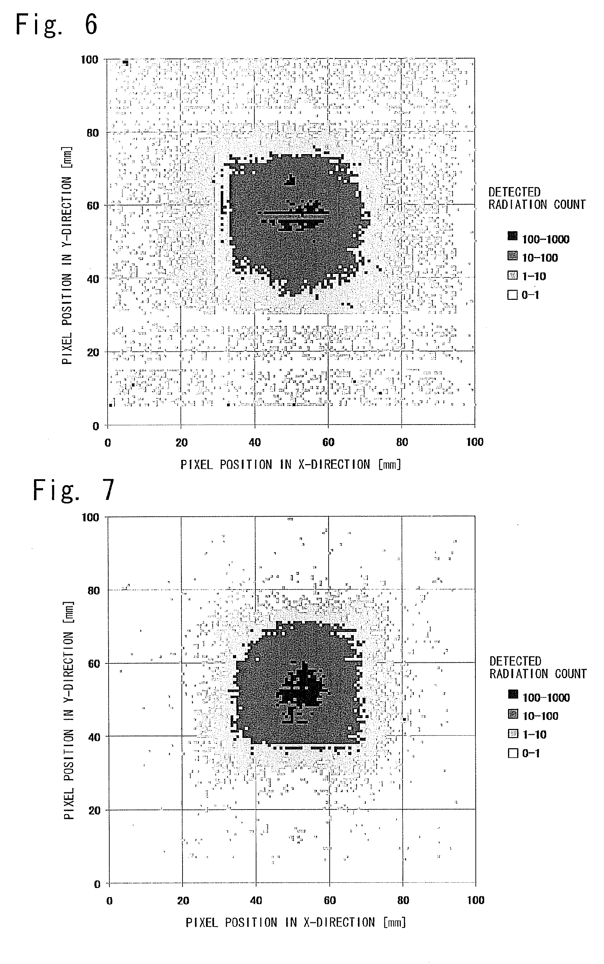

To evaluate the performance of the radiographic image detector, $^{241}$Am isotope having radioactivity of 2. 6 MBq was used as a radiation source, and the response of the radiographic image detector to radiation generated by the radiation source was evaluated. The radiation source was installed near the scintillator, and a proximal surface of the scintillator was irradiated with α-rays generated by the radiation source. Using the signal processing circuit connected to the pixel electrode, signals outputted from each anode electrode of the pixel electrode were acquired to constitute a two-dimensional image. As a result, the shape of the scintillator could be grasped as an image, as shown in Fig. 6. Thus, the radiographic image detector of the present invention was confirmed to have sufficient sensitivity and excellent position resolution. In response to the incidence of radiation at a frequency of 2.6 MBq, the operation of the radiographic image detector was not impeded, so that the radiographic image detector was confirmed to be also excellent in count rate characteristic.

Examples 2

<Scintillator>

A lanthanum fluoride crystal containing neodymium as a luminescence center element, which was produced in Example 1, was used as the scintillator.

<Preparation of gas multiplication ultraviolet image detector>

A gas multiplication ultraviolet image detector was prepared in the following manner:
As shown in Fig. 2, two gas electron multipliers and a pixel electrode were installed parallel in this sequence within a chamber having an opening, starting on the side nearer the opening, and the opening was sealed with an ultraviolet entrance window. The distance between the ultraviolet entrance window and the gas electron multiplier at the first stage was 2.5 mm, the distance between the gas electron multiplier at the first stage and the gas electron multiplier at the subsequent stage was 2 mm, and the distance between the gas electron multiplier at the subsequent stage and the pixel electrode was 2 mm. As the gas electron multiplier at the first stage, there was used a plate-shaped multilayer body comprising many metal layers coated on both sides of a 100 $\mu$m thick plate-shaped insulating layer (VECSTAR, KURARAY CO., LTD.) formed from a liquid crystal polymer. The many metal layers were prepared by vapor-depositing copper, nickel and gold in thicknesses of 5 $\mu$m, 2 $\mu$m, and 0.2 $\mu$m, respectively, in this order, starting on the side closer to the plate-shaped insulating layer. Throughout the plate-shaped multilayer body, cylindrical through-holes of 70 $\mu$m in diameter were provided at a pitch of 140 $\mu$m in an arrangement of regular triangles to constitute the gas electron multiplier. As the gas electron multiplier at the subsequent stage, the same as that in Example 1 was used.

In the present Example, a thin film of cesium iodide was provided, as a photoelectric conversion substance, on a surface of the gas electron multiplier at the first stage that opposed the ultraviolet entrance window. The pixel electrode used was the same as that in Example 1. For the ultraviolet entrance window, $MgF_2$ having a diameter of 70 mm and a thickness of 5 mm was used.

High voltage power supplies for applying applied voltages were connected to both surfaces of the gas electron multiplier at the first stage; to both surfaces of the gas electron multiplier at the subsequent stage; and to the anode electrodes and cathode electrodes of the pixel electrode. A signal processing circuit for reading out signals and obtaining a two-dimensional image was connected to the anode electrodes and cathode electrodes of the pixel electrode. An Ar gas incorporating 10% of $C_2H_6$ was charged into the chamber to obtain a gas multiplication ultraviolet image detector, a constituent element of the present invention.

In the gas multiplication ultraviolet image detector, 300 V was applied between the metal layers on the opposite surfaces in each of the two gas electron multipliers, and 400 V was applied between the anode electrodes and cathode electrodes of the pixel electrode. The applied voltages were adjusted such that the electric field between the ultraviolet entrance window and the gas electron multiplier at the first stage was 0.48 kV/cm, the electric field between the gas electron multiplier at the first stage and the gas electron multiplier at the subsequent stage was 1.25 kV/cm, and the electric field between the gas electron multiplier at the subsequent stage and the pixel electrode was 2.5 kV/cm.

Under the above applied voltages, the overall multiplication factor obtained by the two gas electron multipliers and the pixel electrode reached $1.3 \times 10^5$. Even at such a high multiplication factor, electric discharge at the face or back of the gas electron multiplier, or electric discharge in the pixel electrode did not occur, and the gas multiplication ultraviolet image detector was confirmed to operate stably for a long period of time.

<Preparation and evaluation of radiographic image detector>

The scintillator and the gas multiplication ultraviolet image detector prepared above were installed, with the ultraviolet emergence surface of the scintillator and the ultraviolet entrance window of the gas multiplication ultraviolet image detector being in intimate contact as shown in Fig. 2, to obtain the radiographic image detector of the present invention. The clearance between the ultraviolet emergence surface and the ultraviolet entrance window was filled with "Krytox" of DuPont as fluorine-based optical grease.

Evaluation of the performance of the radiographic image detector was made by using $^{241}$Am isotope having radioactivity of 2.6 MBq as a radiation source, and evaluating the response of the radiographic image detector to radiation generated by the radiation source, similarly to Example 1. As a result, the shape of the scintillator could be grasped as an image, as shown in Fig. 7. Thus, the radiographic image detector of the present invention was confirmed to have sufficient sensitivity and excellent position resolution. In response to the incidence of radiation at a frequency of 2.6 MBq, the operation of the radiographic image detector was not impeded, so that the radiographic image detector was confirmed to be also excellent in count rate characteristic.

Example 3

<Preparation of scintillator>

The lanthanum fluoride crystal containing neodymium as a luminescence center element, which was produced in Example 1, was used as the scintillator. This scintillator was processed into a $3 \times 3 \times 10$ mm$^3$ rectangular parallelepiped by a wire saw provided with a diamond wire, and was then optically polished on all surfaces. Of the optically polished surfaces, the one surface measuring $3 \times 3$ mm$^2$ was used as an ultraviolet emergence surface, while the four surfaces except the ultraviolet emergence surface and the surface opposing it were coated with an ultraviolet reflective film comprising Teflon. Nine of the so prepared scintillators were rendered ready for use, and each scintillator was arranged such that its ultraviolet emergence surface was placed in the same plane, whereby a scintillator array in a $3 \times 3$ arrangement was prepared.

<Preparation of gas multiplication ultraviolet image detector>

A gas multiplication ultraviolet image detector was prepared in the same manner as in Example 1.

In the gas multiplication ultraviolet image detector, -1250 V was applied to the electrode comprising the aluminum layer that was provided in the outer peripheral portion on the cesium iodide thin film, 300 V was applied between the metal layers on the opposite surfaces in each of the two gas electron multipliers, and 400 V was applied between the anode electrodes and cathode electrodes of the pixel electrode. The applied voltages were adjusted such that the electric field between the ultraviolet entrance window and the gas electron multiplier at the first stage was 0.8 kV/cm, the electric field between the gas electron multiplier at the first stage and the gas electron multiplier at the subsequent stage was 1.25 kV/cm, and the electric field between the gas electron multiplier at the subsequent stage and the pixel electrode was 3.0 kV/cm.

Under the above applied voltages, the overall multiplication factor obtained by the two gas electron multipliers and the pixel electrode reached $6.0 \times 10^5$. Even at such a high multiplication factor, electric discharge at the face or back of the gas electron multiplier, or electric discharge in the pixel electrode did not occur, and the gas multiplication ultraviolet image detector was confirmed to operate stably for a long period of time.

<Preparation and evaluation of radiographic image detector>

The scintillator array and the gas multiplication ultraviolet image detector were installed, with the ultraviolet emergence surfaces of the scintillator array and the ultraviolet entrance window of the gas multiplication ultraviolet image detector being in intimate contact as shown in Fig. 3, to obtain the radiographic image detector of the present invention. The clearance between the ultraviolet emergence surfaces and the ultraviolet entrance window was filled with "Krytox" of DuPont as fluorine-based optical grease.

To evaluate the performance of the radiographic image detector of the present invention, $^{241}$Am isotope having radioactivity of 8 kBq was used as a radiation source, and the response of the radiographic image detector to radiation generated by the radiation source was evaluated. The radiation source was installed near the scintillator, and a proximal surface of the scintillator was irradiated with $\alpha$-rays generated by the radiation source. In the present Example, the scintillators located at the lower left position, the central position, and the upper right position of the scintillator array in the $3 \times 3$ arrangement were individually irradiated with $\alpha$-rays to conduct evaluation. That is, the scintillator array was covered with a shield, and only a site of the shield corresponding to the scintillator targeted for irradiation was provided with an opening. Through this opening, only the scintillator targeted for irradiation was irradiated with $\alpha$-rays. Using a signal processing circuit connected to the pixel electrode, signals outputted from each anode electrode of the pixel electrode were acquired to constitute a two-dimensional image.

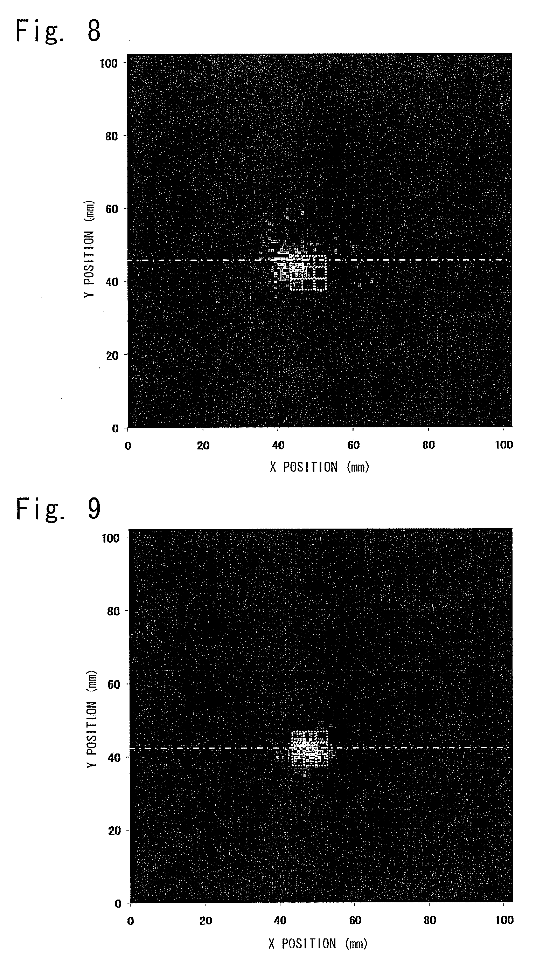

The results obtained upon individual irradiation of the scintillators located at the upper left position, the central position, and the lower right position of the scintillator array in the $3 \times 3$ arrangement are shown in Figs. 8, 9 and 10, respectively. In these drawings, the short dashed line parts (square lines) denote the position where the scintillator array was installed. The image was constituted on a 256-level gray scale, with the pixel at the highest frequency of radiation detection as white, and the pixel at the lowest frequency of radiation detection as black. These results demonstrate that according to the radiographic image detector of the present invention, the position of the scintillator, namely, the position of incidence of radiation, can be identified.

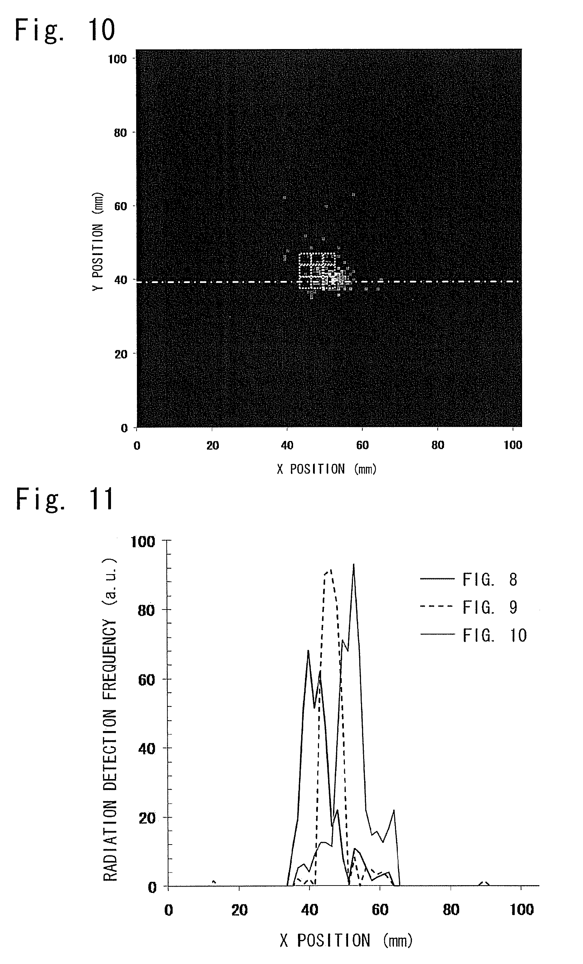

The profiles of the frequencies of radiation detection along the dashed dotted lines (horizontal straight lines) in Figs. 8, 9 and 10 are shown in Fig. 11. From the profile of the frequency of radiation detection, the position of the scintillator can be clearly identified. It can be confirmed, therefore, that the radiographic image detector of the present invention has sufficient sensitivity and excellent position resolution.

Explanations of Letters or Numerals:

1    Scintillator

2    Photoelectric conversion substance

3    Primary electrons

4    Gas electron multiplier

5    Secondary electrons

6    Pixel electrode

7        Chamber

8        Ultraviolet entrance window

9        Electrode

10       Ultraviolet reflective film

11       Optical grease

12       Plate-shaped insulating layer

13       Metal layer

14       Through-hole

**Claims**

1. A radiographic image detector including a scintillator for converting incident radiation into ultraviolet rays, and a gas multiplication ultraviolet image detector,
   wherein the gas multiplication ultraviolet image detector is composed of a photoelectric conversion substance, a gas electron multiplier, and a pixel electrode.

2. The radiographic image detector according to claim 1, wherein
   the scintillator is a metal fluoride crystal containing neodymium, praseodymium, thulium or erbium.

3. The radiographic image detector according to claim 1, wherein
   the photoelectric conversion substance is cesium iodide or cesium telluride.

4. The radiographic image detector according to claim 1, wherein
   two or three of the gas electron multipliers are present.

Fig. 1

Fig. 2

# Fig. 3

RADIATION

ULTRAVIOLET RAY

1

10

11

8

9

2

3

4

5

6

7

# Fig. 4

RADIATION

ULTRAVIOLET
RAY

1

8

10

9

2

3

4

5

6

7

# Fig. 5

PLAN VIEW

14

13
12
13

$D_m$
$D_i$
$D_m$

SECTIONAL VIEW

## Fig. 6

## Fig. 7

Fig. 8

Fig. 9

Fig. 10

Fig. 11

**INTERNATIONAL SEARCH REPORT**

| International application No. |
|---|
| PCT/JP2010/054836 |

A. CLASSIFICATION OF SUBJECT MATTER
*G01T1/18*(2006.01)i, *G01T1/20*(2006.01)i, *H01J31/50*(2006.01)i

According to International Patent Classification (IPC) or to both national classification and IPC

B. FIELDS SEARCHED

Minimum documentation searched (classification system followed by classification symbols)
G01T1/18, G01T1/20, H01J31/50

Documentation searched other than minimum documentation to the extent that such documents are included in the fields searched
Jitsuyo Shinan Koho        1922-1996    Jitsuyo Shinan Toroku Koho    1996-2010
Kokai Jitsuyo Shinan Koho  1971-2010    Toroku Jitsuyo Shinan Koho    1994-2010

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | WO 2006/115249 A1  (Riken, Japan),<br>02 November 2006 (02.11.2006),<br>entire text; all drawings<br>& JP 2006-302844 A | 1-4 |
| Y | JP 2008-202977 A  (Tokuyama Corp.),<br>04 September 2008 (04.09.2008),<br>entire text; all drawings<br>& US 2010/0001191 A       & EP 2112529 A1<br>& WO 2008/099971 A1      & KR 10-2009-0119824 A | 1-4 |

☒ Further documents are listed in the continuation of Box C.     ☐ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search<br>11 May, 2010 (11.05.10) | Date of mailing of the international search report<br>18 May, 2010 (18.05.10) |
|---|---|
| Name and mailing address of the ISA/<br>Japanese Patent Office | Authorized officer |
| Facsimile No. | Telephone No. |

Form PCT/ISA/210 (second sheet) (July 2009)

**INTERNATIONAL SEARCH REPORT**

| International application No. |
| --- |
| PCT/JP2010/054836 |

C (Continuation).   DOCUMENTS CONSIDERED TO BE RELEVANT

| Category* | Citation of document, with indication, where appropriate, of the relevant passages | Relevant to claim No. |
| --- | --- | --- |
| Y | JP 7-140068 A  (Bodenseewerk Perkin Elmer GmbH), 02 June 1995 (02.06.1995), paragraphs [0008] to [0010] & GB 2278438 A          & DE 4316513 A & DE 4333572 A          & FR 2705459 A & AU 6308594 A          & IT 1269778 A & IT 1269778 B          & IT 94500977 A0 | 3 |
| Y | JP 2001-4555 A  (Hamamatsu Photonics Kabushiki Kaisha), 12 January 2001 (12.01.2001), paragraph [0013] (Family: none) | 3 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 3354551 B
- JP 2008202977 A
- JP 2006302844 A
- JP 2007234485 A

### Non-patent literature cited in the description

- **P. Schotanus et al.** Detection of LaF3:Nd3+ Scintillation Light in a Photosensitive Mutiwire Chamber. *Nuclear Instruments and Methods in Physics Research,* 1988, vol. A272, 913-916
- **J. Va'vra.** Wire Aging of Hydrocarbon Gases with TMAE Additions. *IEEE Transactions on Nuclear Science,* 1987, vol. NS-34, 486-490
- **J. van der Marel et al.** A LaF3:Nd (10%) Scintillation Detector with Microgap Gas Chamber Read-out for the Detection of γ-rays. *Nuclear Instruments and Methods in Physics Research,* 1997, vol. A392, 310-314